# EUROPEAN PATENT APPLICATION

(11) **EP 4 842 193 A1**
(43) Date of publication of application: **18.11.2026**
(21) Application number: 26176832.9
(22) Date of filing: 06.05.2026
(51) Int. Cl.: H10W 70/63, H10W 44/20, H10W 70/05, H10W 70/685, H10W 90/00

(54) **REDUCING IMPEDANCE MISMATCH BETWEEN VIAS AND MICROVIAS IN A PACKAGING SUBSTRATE**

(30) Priority: 15.05.2025 US 202519209736
(71) Applicant: Avago Technologies International Sales Pte. Limited, Singapore 768923 (SG)
(72) Inventor: Saraswat, Dharmendra, Irvine, 92618 (US); Karikalan, Sampath, Irvine, 92618 (US)
(74) Representative: Bosch Jehle Patentanwaltsgesellschaft mbH

(57) **Abstract**

This application discloses integrated circuits, packages, and other semiconductors that feature microvias in communication with vias. In some aspects, the microvias are arranged to reduce an impedance mismatch between the via and the microvias. For instance, a plurality of microvias extending through one or more layers might be in communication with a via extending through one or more other layers. In some cases, the microvias might be parallel.

## Description

This disclosure relates to semiconductors in general and more particularly to semiconductors having multiple microvias..

Semiconductor devices often have many layers, and those layers often include conductive regions, non-conductive regions, and semi-conductive regions, which can support logic gates, transistors, diodes, capacitors, and other functional components. Such components often are connected by traces, which generally comprise conductive materials (e.g., gold, copper, aluminum, etc.) that are deposited onto the surface of a semiconductor material (e.g., with photolithography, etching, and metallization). Traces can perform various tasks, such as signal transmission, power distribution, grounding, and interconnection of components to form a circuit. While a trace generally runs across a layer, a via generally runs through a layer and/or from one layer to another, providing many of the same functions that a trace performs but between layers, rather than within a single layer.

As the performance of semiconductor devices increases and the size thereof decreases, space in the layout of the IC and/or the package becomes a primary consideration. As manufacturing processes have evolved, many semiconductor manufacturers have begun to use microvias in place of vias through some layers. Microvias can provide a variety of benefits over vias, including without limitation higher interconnect density, design flexibility, reduced layer count, better thermal and/or mechanical performance, and/or compatibility with advanced manufacturing.

The use of microvias, however, can create structural discontinuity in the transition from a via in one layer of the device to a microvia in another layer. This structural discontinuity can result in unwanted side effects and/or reduced performance, particularly in circuits operating at high frequencies.
According to an aspect, package for an integrated circuit is provided, the package comprising:
a via structure, comprising:
a first signal via extending through a first layer of the package;
a first set of signal microvias comprising a first plurality of signal microvias extending through a second layer of the package and in electrical communication with the first signal via.

Advantageously, the package further comprises a core area, wherein the first set of signal microvias is disposed in the core area.

Advantageously, the package further comprises a die breakout area, wherein the first set of signal microvias is disposed in the die breakout area.

Advantageously, the package further comprises a bottom buildup area, wherein the first set of signal microvias is disposed in the bottom buildup area.

Advantageously, the package comprises a ball gate array (BGA).

Advantageously, the first plurality of signal microvias are disposed in parallel.

Advantageously, the first plurality of signal microvias consists of two signal microvias.

Advantageously, each of the signal microvias has substantially a same cross-sectional area and substantially a same height.

Advantageously, the first layer is above the second layer.

Advantageously, the package further comprises:
a second signal via extending through the first layer;
a second set of signal microvias comprising a second plurality of signal microvias extending through the second layer and in electrical communication with the second signal via.

Advantageously, the first set of signal microvias is part of a positive signal path of a differential pair for high-speed signaling and the second set of signal microvias is part of a negative signal path of the differential pair.

Advantageously, the high-speed signaling operates at a clock rate of at least 45 GHz.

Advantageously, a ratio of a positive/negative terminal spacing between the first set of signal microvias and the second set of signal microvias to a height of the signal microvias is between 1.7 and 1.9.

Advantageously, a ratio of a spacing between each of the signal microvias to a height of each of at least one of the signal microvias is between 0.48 and 0.56.

Advantageously, a ratio of a spacing between the set of signal microvias and a ground microvia to a height of the at least one of the signal microvias is between 0.8 and 1.0.

Advantageously, the first set of signal microvias extends through a plurality of layers of the package.

According to an aspect, a semiconductor device is provided comprising:
a via structure, comprising:
a first signal via extending through a first layer of the semiconductor device;
a first set of signal microvias comprising a first plurality of signal microvias extending through a second layer of the semiconductor device and in electrical communication with the first signal via;
a second signal via extending through the first layer; and
a second set of signal microvias comprising a second plurality of signal microvias extending through the second layer and in electrical communication with the second signal via;
wherein the first set of signal microvias is part of a positive signal path of a differential pair for high-speed signaling and the second set of signal microvias is part of a negative signal path of the differential pair.

Advantageously, the semiconductor device comprises an integrated circuit and a package, and wherein the package comprises the via structure.

According to an aspect, a network device is provided, comprising:
a semiconductor device, comprising:
a via structure comprising:
a signal via extending through a first layer of the semiconductor device; and
a plurality of signal microvias extending through a second layer of the semiconductor device and in electrical communication with the core via.

Advantageously, the semiconductor device comprises one or more serializer-deserializer (SERDES) blocks.

### Brief Description of the Drawings

Fig. 1 is a sectional view of a semiconductor device, in accordance with some embodiments.
Fig. 2 is an isometric drawing of a semiconductor device comprising a via structure, in accordance with some embodiments.
Fig. 3A is a side elevation view of the semiconductor device of Fig. 2, in accordance with some embodiments.
Fig. 3B is a front elevation view of the semiconductor device of Fig. 2, in accordance with some embodiments.
Fig. 4A is a plan view of a first layer of the semiconductor device of Fig. 2, in accordance with some embodiments.
Fig. 4B is a plan view of a second layer of the semiconductor device of Fig. 2, in accordance with some embodiments.
Fig. 4C is a plan view of a third layer of the semiconductor device of Fig. 2, in accordance with some embodiments.
Fig. 5 is an elevation view of a plurality of microvias, in accordance with some embodiments.
Fig. 6 is a functional diagram illustrating a network device, in accordance with some embodiments.
Fig. 7 is a flow diagram illustrating a method of producing a semiconductor device comprising microvias, in accordance with some embodiments.
Fig. 8 is a flow diagram illustrating a method of producing a device comprising a semiconductor device, in accordance with some embodiments.
Fig. 9 is a flow diagram illustrating a method of using a semiconductor device comprising microvias and/or of using a device comprising such a semiconductor device, in accordance with some embodiments.

### Detailed Description

Certain embodiments provide semiconductors comprising sets of microvias that can reduce impedance mismatch between traditional vias (referred to herein as "vias") and microvias. As used herein, the term "via" broadly refers to a through-hole extending through one or more layers of a semiconductor device that is filled with a conducting material (*e.g.,* copper, aluminum, gold, etc.) and that can conduct power and/or carry signals between electronics (*e.g.,* a landing pad, traces, circuits, components, etc.) on different layers of the semiconductor device. The term "microvia," as used herein, refers to a through hole, filled with a conducting material, extending through one or more layers of a semiconductor device that has a diameter (or cross-sectional area) sufficiently smaller than that of a via that, when a single microvia is in electrical communication with a via, the transition to and/or from the via to the microvia produces an impedance discontinuity sufficient to produce significant insertion and/or return loss in signals carried by the via and microvia. Generally, a via will have a diameter of 100 micrometers or greater, while a microvia generally has a diameter of less than 100 micrometers; in a typical application, a via might have a diameter of at least 150 micrometers, while a microvia might have a diameter no greater than 65 micrometers, although embodiments are not so limited. Vias and microvias generally can be classified as "power" vias or microvias, that conduct power through layers of a semiconductor device, "signal" vias or microvias that carry signals through layers of a semiconductor device, and "ground" vias or microvias that provide electrical communication between one or more layers of a semiconductor device and a ground plane (or layer) of the semiconductor device.

In semiconductor designs, a microvia generally exhibits higher impedance than a standard via, often due to differences in their geometries and material properties. The smaller diameter and often higher aspect ratio (depth-to-diameter ratio) of microvias result in higher resistance, as resistance is proportional to the length of the conductive path and inversely proportional to the cross-sectional area of the conductive path.

Additionally, high-aspect-ratio microvias are susceptible to manufacturing defects, such as incomplete copper plating or voids, which further increase resistance.

Impedance in both vias and microvias comprises resistance and the net reactance, which is the difference between inductive reactance, which is proportional to signal frequency, and capacitive reactance, which is inversely proportional to signal frequency. Relative to vias, microvias typically have higher inductance, *e.g.,* due to their narrower conductive paths, which concentrate magnetic fields, and lower capacitance, *e.g.,* due to their smaller surface area and thinner dielectric layers in high-density interconnects. These differences contribute to an impedance mismatch between vias and microvias.

As signal frequency increases, the impedance mismatch often becomes more pronounced because inductive reactance grows linearly with frequency, while capacitive reactance decreases inversely. This shift amplifies the impact of microvias' higher inductance, particularly in high-speed circuits operating at GHz frequencies. Other factors, such as the skin effect at high frequencies or variations in copper plating quality, can also influence impedance but generally are secondary to geometric effects. In high-speed semiconductor applications, the impedance mismatch between vias and microvias can cause insertion and/or return loss, degrading signal integrity, *e.g.,* by introducing reflections, attenuation, or waveform distortion.

Some embodiments therefore provide multiple microvias, rather than a single microvia, in communication with a via. These multiple microvias can increase the effective diameter (and correspondingly reduce the effective aspect ratio) of the signal path through the microvia region. Especially in the case of signal vias and microvias, this reduction in impedance mismatch can reduce the negative impacts thereof (*e.g.,* insertion and/or return loss)

Often, an integrated circuit, also referred to herein as an "IC" or "chip," will be enclosed within a package during the manufacturing process. The package can provide a covering to prevent physical damage, a thermal path for heat dissipation, and/or distribution of electrical connections between the device and other structures (*e.g.,* printed circuit boards (PCB)). There are a variety of different types of packages, including through-hole packages, surface mount packages, flip chip packages, and the like. As used herein, the terms, "semiconductor device," and "semiconductor" are used broadly and synonymously to refer to a chip itself, a package for a chip, and/or the combination of a chip and an enclosing package, unless the context dictates otherwise.

### Exemplary Embodiments

Certain exemplary embodiments are described below. Each of the described embodiments can be implemented separately or in any combination, as would be appreciated by one skilled in the art. Thus, no single embodiment or combination of embodiments should be considered limiting.

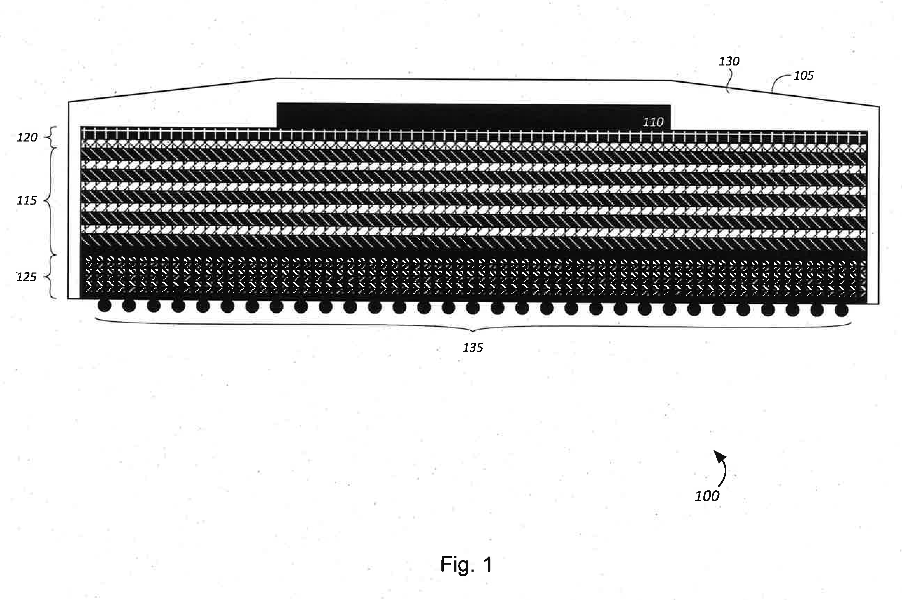

Fig. 1 illustrates an example of a semiconductor device 100, in accordance with some embodiments. In the illustrated example, the semiconductor device 100 comprises a package 105 enclosing an IC 110. (In some cases, as noted above, however, the semiconductor device 100 might comprise the package 105 but not the IC 110, or the IC 110 but not the package 105).

In some embodiments the IC 110 can be any type of IC that might employ microvias, including without limitation a central processing unit (CPU); graphics processing unit (GPU); an accelerator device (including without limitation an artificial intelligence (AI) accelerator); and/or any other type of other processing unit (xPU), which can include without limitation CPUs, GPUs, tensor processing units (TPU), data processing unit (DPU), network processing unit (NPU), neural processing unit, vision processing unit (VPU), field programmable gate arrays (FPGA), and/or the like. Further examples of ICs in accordance with various embodiments can comprise systems on a chip (SoC) and/or application specific integrated circuits (ASIC), including without limitation application processors, modem ICs, etc.; memory chips, *e.g.,* high-bandwidth memory (HBM), dynamic access memory (DRAM), three dimensional flash memory (*e.g.,* 3D NAND flash), etc.; and/or automotive chips, such as advanced driver-assistance system (ADAS) processors, automotive microcontrollers, etc., Internet of Things (IoT) chips, and wearable processors.

In some embodiments, the IC 110 might be a wired network processor (for example, a chip that can be used in a networking device, *e.g.,* as described in further detail below), such as a switch and/or router ASIC, which might include one or more serializer-deserializer (SERDES) blocks, that can perform, *e.g.,* Layer 2 switching, Layer 3 routing, traffic management, etc., and/or support terabits-per-second bandwidth (*e.g.,* 6.4-25.6 Tbps) with hundreds of processing cores or pipelines. Examples of such chips include, without limitation, the Trident^{™} and Tomahawk^{™} lines of chips manufactured by Broadcom and similar chips from other manufacturers. In some embodiments, the IC can be a wireless chip, such as a wireless SoC, a wireless connectivity chip, etc., which can support cellular (5G), Wi-Fi (*e.g.,* IEEE 802.11 compliant), Bluetooth, Zigbee, and/or any other suitable wireless communication protocols. ICs in accordance with other embodiments can include standalone SERDES physical layer (PHY) chips.

The package 105 can be any type of package that can employ microvias, including without limitation, ball grid array (BGA), flip-chip ball grid array (FC-BGA), fan-out wafer-level packaging (FOWLP), system-in-package (SiP), 2.5-dimension packaging (2.5D), three dimension IC packaging (3D IC), wafer-level chip-scale package (WLCSP), embedded multi-die interconnect bridge (EMIB), chip-on-wafer-on-substrate (CoWoS), and/or the like.

The package 105 can comprise multiple areas or regions, such as a core area 115, a die breakout area 120, and/or a bottom buildup area 125. In various embodiments, the die breakout area 120 might be considered a portion of the core area 115.

It should be noted that the illustration of the IC 110 and package 105 in Fig. 1 necessarily is simplified. For example, the skilled artisan will recognize that the IC 110 generally will comprise a variety of layers, none of which are illustrated in Fig. 1. Moreover, while Fig. 1 illustrates a bottom buildup area 125, it should be appreciated that, in many embodiments, the package 105 might include a top buildup area, which is not illustrated on Fig. 1 but comprise one or more layers disposed between the core area 115 and the die breakout area 120; for purposes of this disclosure, the die breakout area 120 should be considered to include any such top buildup area. Moreover, some or all of the layers in each area of the package 105 (and in the IC 110) will comprise vias, microvias, and/or traces (which can carry signal, power, and/or ground connections, and are collectively referred to herein as "interconnect")..

Each of the areas 115, 120, 125 of the package 105 can include a plurality of layers (indicated by the different fill patterns of various layers in Fig. 1). Each layer can have different functions or purposes, which are outside the scope of this disclosure, but in general, circuitry on different layers is connected by interconnect, which for the sake of simplicity, are not illustrated on Fig. 1.

In a general sense, the core area 115 can be considered the central, structural backbone of the package substrate, typically set of rigid layer or material that provides mechanical stability and supports the overall package architecture. It serves as the foundation for the multilayer structure of the package 105, hosting vias, microvias, traces, and other interconnects. The core area 115 can provide mechanical support to maintain package integrity, distribute power and ground from the PCB to the die of the IC 110 via large planes and vias/microvias, provide a signal routing foundation of interconnect connecting the PCB (through the bottom buildup area 125) to the die of the IC (through the die breakout area 120), provide thermal management with conductive paths, and/or provide protection to the IC 110 from electrostatic discharge (ESD) and/or electromagnetic interference (EMI).

The die breakout 120 area can be considered the region of the package substrate directly beneath or around the IC 110, where the IC die's input/output pads or bumps (not shown in Fig. 1) connect to the electrical routing network (*e.g.,* interconnect) of the core area 115. The die breakout area 120, in an aspect, serves to "break out" the die's fine-pitch signal, power, and ground connections into the coarser pitch of the interconnects of the core area 115. Depending on the embodiment, the die breakout area 120 might comprise wire bonding with the die of the IC 110, solder balls (*e.g.,* in a flip-chip package), and/or other connections between the package 105 and the IC 110).

The bottom buildup area 125 can provide signal routing between the core area 115 and the package's connections to the underlying PCB, delivery of power received from package's PCB connections to the core area 115 (and from there to the die breakout area 120 and ultimately the die of the IC 110), provision of thermal paths to thermal balls, provision of a ground path from the PCB connections to a ground plane of the core area 115 and from there, through the breakout area 120 and ultimately the die; transition (fan-out) from dense core interconnect to coarse pitch PCB connections, and enhancement of the structural integrity of the package 105, especially during in embodiments where the package 105 is soldered to the PCB.

In some cases, the package 105 also comprises a protective cover 130, which can include molding compound, lid, underfill, and/or solder mask, that shields the IC 110 die and package 105 layers (e.g., the core area 115, die breakout area 120, and/or bottom buildup area 125) from mechanical damage, moisture, thermal stress, etc. and/or to provide a thermal sink above the IC 110. In various embodiments, the package 105 also includes contacts for connection with the underlying PCB. Examples include, without limitation, surface mount technology (SMT), in which the package's external contacts (*e.g.,,* solder balls, leads, or pads) are soldered directly onto the surface of the PCB; through-hole technology, in which the package 105 has pins or leads that are inserted into holes drilled through the PCB and soldered on the opposite side; socket-based connections, in which the package 105 is inserted into a socket mounted on the PCB, allowing temporary or removable connections without soldering and the socket's contacts (*e.g.,* pogo pins, spring-loaded pins) interface with the package's pins, pads, or balls, and direct attach (chip-on-board) in which the bare die is directly mounted on the PCB and then covered with an encapsulation.

Fig. 1 illustrates ball grid array (BGA) package, which is one type of surface mount package (although embodiments are not so limited). In the illustrated embodiment, the IC 110 die is attached to the die breakout area 120; in various embodiments, the attachment between the IC 110 die and the die breakout area 120 can comprise wire bonds, or in the case of a flip-chip BGAs, flip chip bumps, etc. As illustrated, a grid of balls 135 (*e.g.,* solder bumps) serve as electrical and/or thermal connections between the IC 110 and the PCB to which the package is connected.

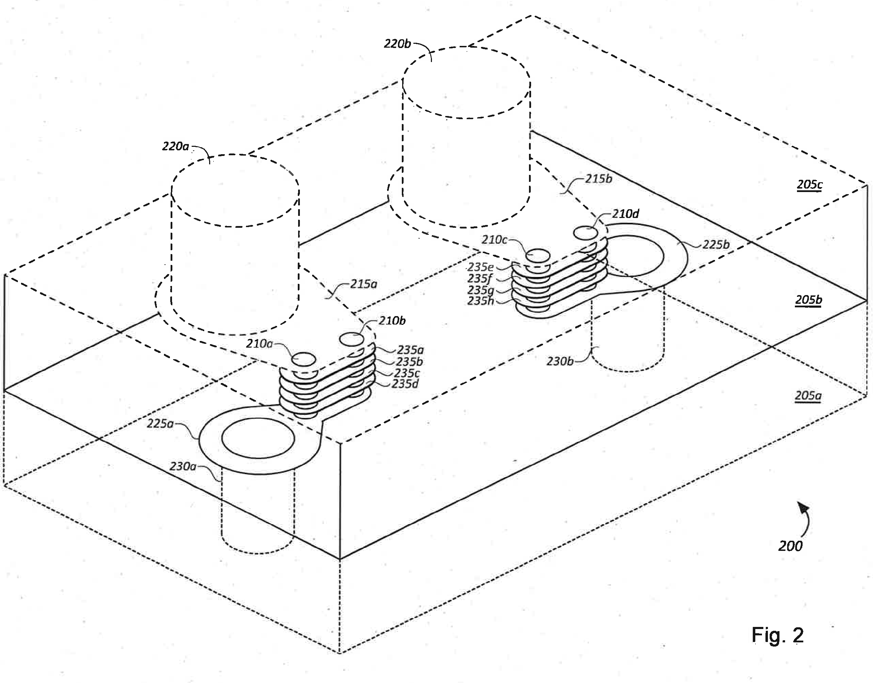

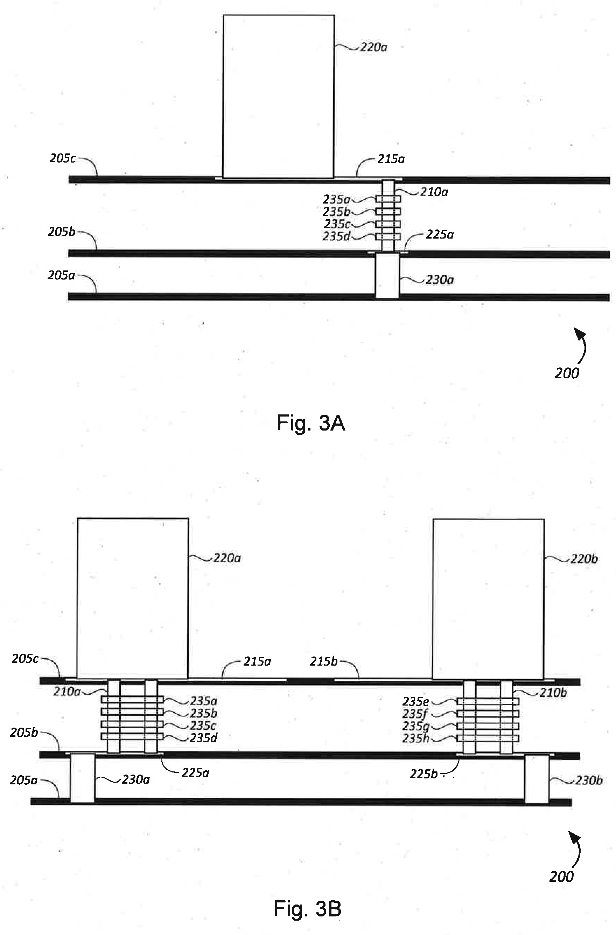

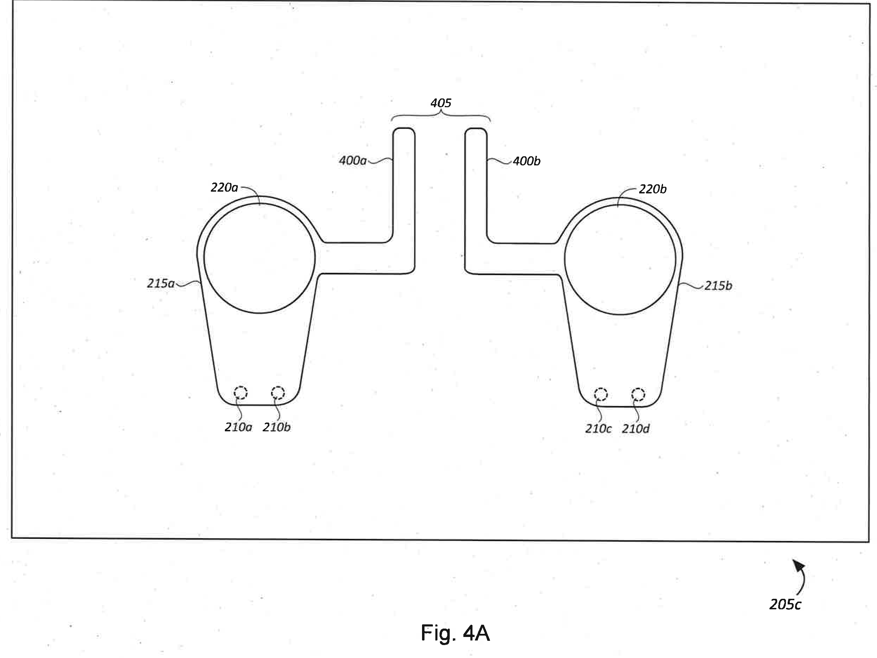

Fig. 2 illustrates a simplified isometric drawing of a semiconductor device 200 comprising a via structure. It should be noted that the simplified drawing of Fig. 2 (along with those of Figs. 3A, 3B, and 4A-4C) are provide merely for explanatory purposes and therefore (1) is not drawn to scale, and (2) illustrates only those components of the semiconductor necessary for understanding the disclosed embodiments and therefore does not include the various components and interconnect that a semiconductor typically will include. The semiconductor device 200, in different embodiments, can be an IC, a package, etc.

As used herein, the term "via structure" is used broadly to refer to any combination of one or more vias and two or more microvias that collectively extends through two or more layers of a semiconductor. For example, the semiconductor includes three layers 205a, 205b, and 205c, depicted by small dashed lines, solid lines, and large dashed lines, respectively. (For purposes of explanation, the bottom surface of one layer can be considered the top surface of the layer below, although this is not true in every embodiment. Further for ease of illustration, the top surface of the top layer 205c is not illustrated.)

The semiconductor device 200 also includes two sets of microvias 120 extending through the middle layer 205b. In some embodiments, the microvias 120 are signal microvias, *i.e.,* microvias that carry a signal, rather than ground or power, through the semiconductor device. The first set of microvias comprises microvias 210a and 210b, and the second set comprises microvias 210c and 210d. Each set of microvias (210a-b and 210c-d, respectively) is in electrical communication though a conductive path (215a and 215b, respectively) with a via (220a and 220b, respectively) extending through the top layer 205c. Each set of microvias (210a-b and 210c-d, respectively) is also in electrical communication though a conductive path (225a and 225b, respectively) with a via (230a and 230b, respectively) extending through the bottom layer 205a. The conductive paths 215a-b and 225a-b can include, without limitation, metallization, traces, landing pads, and/or the like.

In an aspect, a set of microvias (*e.g.,* 210a-b) effectively adds the cross-sectional area of each microvia 210 in the set, effectively reducing the impendence of the set of microvias 210 as compared to a single microvia. In embodiments in which each microvia 210 in the set has the same diameter and/or cross-sectional area, the effective aspect ratio of the set of microvias is reduced proportionally by the number of microvias in the set; thus, for example a set of two microvias of equal diameter (or equivalent, such as diagonal width, in non-circular microvias) has half the effective aspect ratio of a single microvia of the same height. This decreased aspect ratio decreases the impedance of the set correspondingly, reducing the impedance mismatch between the set of microvias 110 and a corresponding via 220 or 230.

In some embodiments, as illustrated by Fig. 2, each set of microvias might include one or more supports 235 supporting each microvia as it extends through the layer 205b. For example, the first set of microvias 210a-b is supported by four supports 235a-d, and the second set of microvias 210c-d is also supported by four supports 235eh. In some embodiments, these supports 235 might comprise conductive material (*e.g.,* the same material that forms the microvias 210), which can be impregnated and/or deposited throughout the middle layer 205b. In some aspects, the supports 235 can provide additional conductivity between each supported microvia 210; in such embodiments, if one microvia (*e.g.,* 210a) in the set somehow breaks or otherwise suffers a discontinuity, the supports (e.g. 235a-d) can allow signals to route around the discontinuity through the other microvia(s) (*e.g.,* 210b) in the set; this can prevent the signal from being carried only by a single microvia (*e.g.,* 210a) for its entire length, thereby maintaining, at least to some extent, the effective aspect ratio of the set of microvias 210a-b and, correspondingly, reducing any impedance mismatch between the set of microvias 210a-b and the corresponding via(s) 220a and/or 230a.

In some embodiments, the structural supports 235 can also help to prevent any such breakage or discontinuity of the supported microvias 210, simply by providing rigid support throughout the height of the middle layer 205b. In particular cases, for example, the supports 235 might be formed in place with the microvias 210 in the set, providing mechanical continuity and rigidity between each of the microvias 210 in the set.

It should be noted that, while Fig. 2 illustrates two microvias 210 in each set and four supports 235 supporting each set, various embodiments can include any arrangement of microvias 210 and/or supports 235. Merely by way of example, in some embodiments, a set of microvias 210 might include any number of microvias (*e.g.,* three or more), and/or any number of supports 235 (*e.g.,* more than four, less than four, or none), depending on the implementation and/or design considerations of the embodiment. Moreover, while each set of microvias 210 is illustrated as being in electrical communication with two vias 220 and 230, this is not required of all embodiments. For example, in some embodiments, a set of microvias 210 often will be attached to at least one via, in some embodiments, *e.g.,* in embodiments in which at least the middle layer 205b is in a die breakout area or a bottom buildup area, a set of microvias 210 might be attached to and/or in electrical communication (*e.g.,* through capture traces or pads, solder ball pads, bump pads, bond pads, etc.) with the solder balls, solder bumps, and/or wire bonds that provide a connection with the IC die or underlying PCB.

Figs. 3A and 3B provide a side elevation view and a front elevation view, respectively, of a semiconductor, *e.g.,* the semiconductor 200 of Fig. 2 in order to better illustrate spatial relationships between the microvias 210 and the vias 220 and 230. Similarly Figs. 4A-C illustrate plan views of the top layer 205c, middle layer 205b, and bottom layer 205C, respectively, of such a semiconductor. It should be noted that, while Figs. 2, 3A-3B, and 4A-4C illustrate particular structural arrangements (*e.g.,* a 90° angle between the top vias 220 and the bottom vias 230, with the microvias 210 providing the vertex of the angle) embodiments are not limited to any such arrangements. Merely by way of example, a top via 220, set of microvias 210, and bottom via 230 might be disposed inline (as viewed in a plan view) and/or stacked vertically through multiple layers. Moreover, in some embodiments, as noted below, the set of microvias 210 might be in communication with only a single via (*e.g.,* via 220 or via 230 but not both). Any number of arrangements are possible, and embodiments are not limited to any particular arrangement unless the context specifies otherwise.

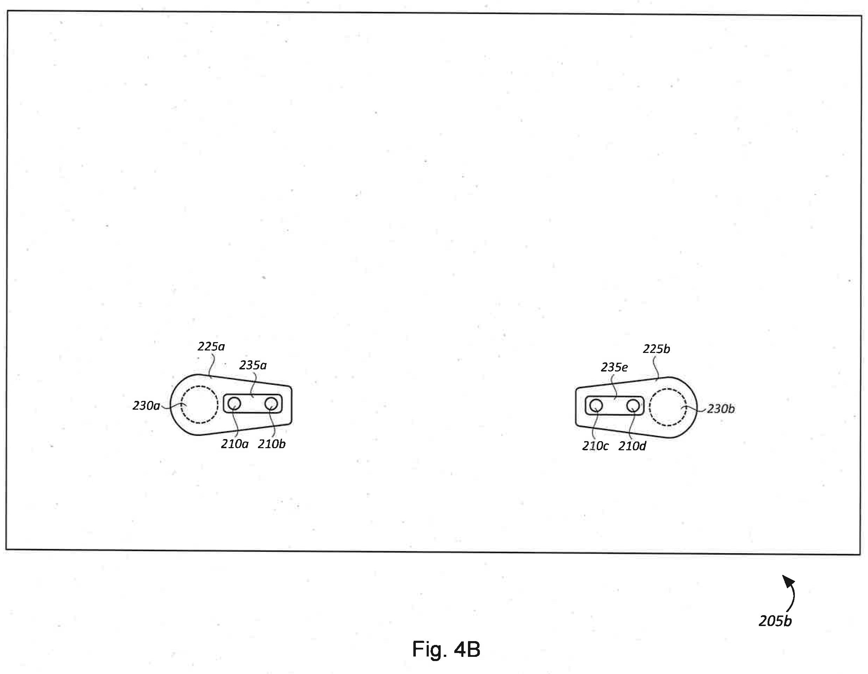

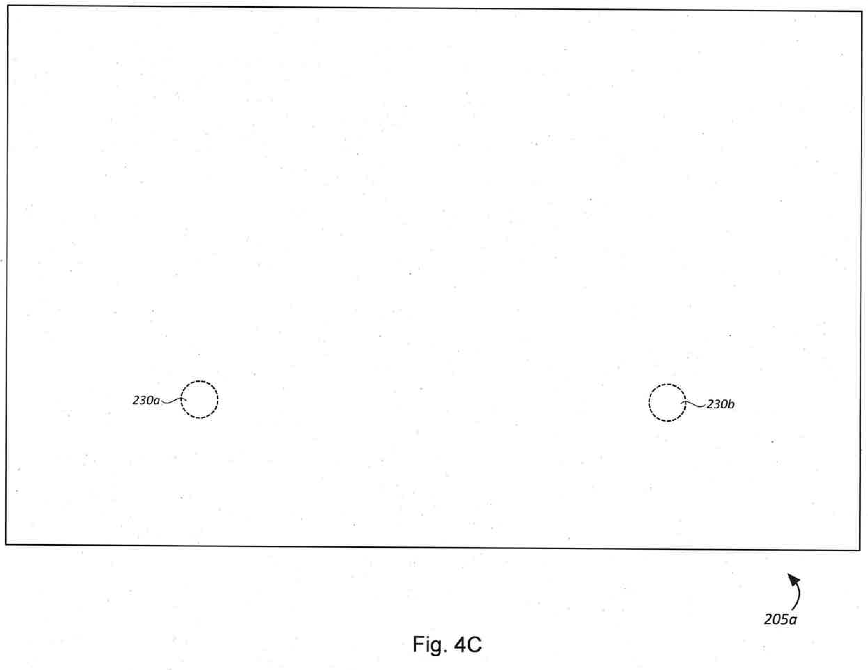

Fig. 4A illustrates the conductive paths 215a, 215b depicted in Fig. 2, which as noted above can each comprise a landing pad, trace, other metallization and/or the like. As illustrated by Fig. 4 (but for simplicity not illustrated on Fig. 2), each conductive path 215a, 215b might include and/or be in electrical communication with a trace 400a, 400b, respectively. (Alternatively, the top of the vias 220a, 220b might be in communication with such traces 400a, 400b, respectively, or similar traces in the layer above layer 205c). In either (or both) cases, embodiments featuring two via structures having such traces 400, the traces 400 can be formed so as to create part of a differential signal path for a differential pair 405, in which each trace 400a, 400b forms a signal path (referred to herein as a "positive terminal" and a "negative terminal," respectively) that transmits a differential signal with a positive and negative component, respectively. The two signal paths in a differential pair are typically routed together, with a controlled distance between them, to maintain a consistent differential impedance. A differential pair often is used for high-speed signaling (*e.g.,* transmission of high-speed signals), because the electrical properties of a differential pair can reject common-mode noise and interference rejection, which can improve signal quality and reduce errors. For this and other reasons, a differential pair can improve signal integrity over longer distances and at higher speeds than single-ended signals, supporting higher bandwidth than single-ended signals.

Thus, for example, in Fig. 4A, the traces 400a and 400b form a differential pair 405. The first set of microvias 210a-b is part of the signal path (through conductive path 215a, via 210a) of one terminal 400a (*e.g.,* the positive terminal) of the differential pair 405, while the second set of microvias 210c-d is part of the signal path of the other terminal 400b (in this case, the negative terminal) of the differential pair 405.

In many cases, the geometry of a set of microvias, including without limitation a set of signal microvias, can affect the electrical properties of the microvias and/or the set of microvias (*e.g.,* differential impedance between of a differential pair, parasitic inductance and/or capacitance, crosstalk between microvias and/or sets of microvias, etc.). Thus, in some embodiments, the geometry of the microvias is managed carefully.

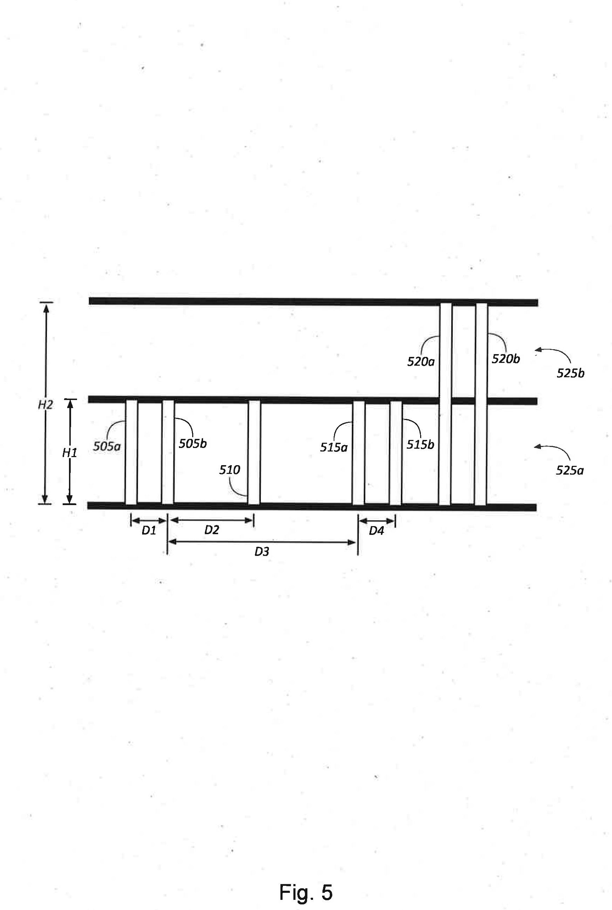

Fig. 5 depicts a simplified elevation of a semiconductor comprising multiple sets of microvias to illustrate some of the relationships involved in microvia geometry. For example, a first set of microvias 505a, 505b has a height (or length) H1 and an intra-set distance (spacing) D1 between the microvias 505a, 505b. The distance D1 is shown as a center-to-center spacing, but in other embodiments, D1 could be measured from the inside or outside edge of one microvia 505a to the inside or outside edge of other microvia 505b (*e.g.,* inside-to-inside spacing, outside-to-outside spacing, etc.) The distance between the set of microvias 505a, 505b and a ground microvia 510 is expressed as D2, while the distance between the first set of microvias 505 and a second set of microvias 515 is expressed as D3. Once again, D2 is shown as a center-to-center distance between the microvia 505b closest to the ground microvia 510 but in other embodiments, it could be a distance from the center of the pair 505 itself to the center of the ground microvia 510 (*i.e.,* 0.5*D1 _ d2) or an edge of the ground microvia 510, the distance from a center (or an edge) of the closed microvia 505b to the ground microvia 510, the distance from the center or an edge of the furthest microvia 505a to the center or an edge of the ground microvia 510, etc.

Likewise, D3 is shown as being measured as a center-to-center distance between the closest microvias 505b and 515a, respectively, of each respective pair 505 and 515, but these distances could be measured, *e.g.,* from the center of one pair 505 to the other pair 515, from an edge or center of the closest microvia 505b or furthest microvia 505a of the first set 505 to an edge of the closest microvia 515a or furthest microvia 515b, a distance from the center of the first set 505 to the center of the second set 515 (*i.e.,* 0.5*D1 + D2 + 0.5*D3), etc.

It should be noted that the first and second set of microvias 505 and 515, respectively, extends through only one layer 525a of the semiconductor, while another set of microvias 520 extends through a plurality of layers (in the illustrated example, two layers 525a, 525b) of the semiconductor and has a height H2. In accordance with embodiments, a microvia or set of microvias can extend through any number of layers in any suitable region(s) of a chip or package.

In some embodiments, the ratio of the spacing D1 between a set of microvias 505 to a height of one or both of the microvias might be any value between 0.2 and 0.8, such as a value between 0.48 and 0.56, and/or a value of approximately 0.52, depending on the embodiment. In some embodiments, the ratio of the spacing D2 between the set of microvias 505 and the ground microvia 510 to a height H1 of one or both of the microvias 505 in the set might be any value in any range between 0.5 and 1.5, such as a value between 0.8 and 1.0, and/or a value of approximately 0.9. In some embodiments, when two sets of microvias that are part of a differential pair (*e.g.,* as described above with respect to Fig. 4A), the spacing between the two sets (also referred to herein as the terminal spacing of the microvia sets in the terminal pair) might be any value between 1.0 and 3.0, such as a value between 1.7 and 1.9 and/or a value of approximately 1.8.

As noted above, in some cases a semiconductor employing one or more sets of microvias can support high-speed operational rates, such as clock rates and/or signal transmission rates. In some cases, these high-speed rates can be at least 45 GHz. A skilled artisan should appreciate that such semiconductors (including ICs, packages, and/or packaged ICs) can have a variety of uses in various computing devices. One category of such devices is network devices.

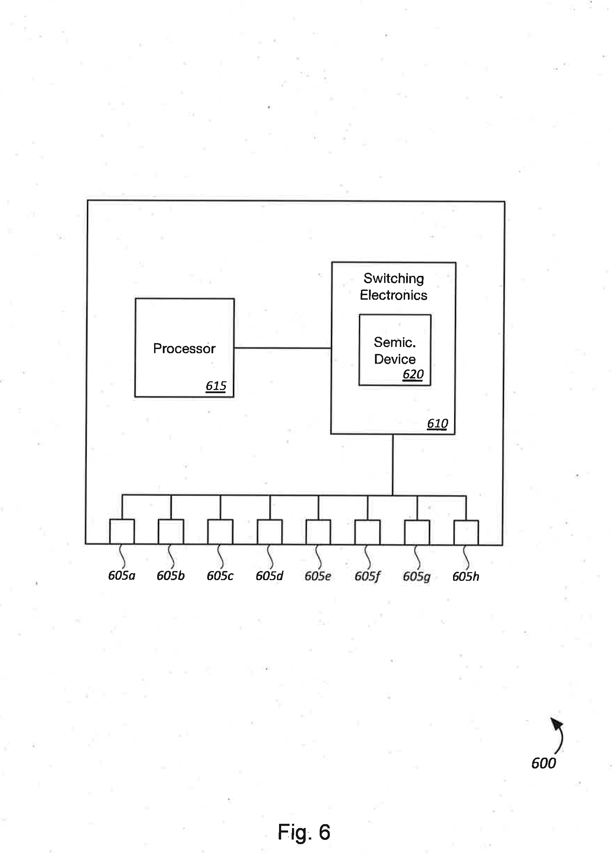

Fig. 6 provides a simplified diagram of a network device 600. As noted in the context of other drawings hereof, the network device 600 of Fig. 6 includes only those components necessary for understanding of disclosed embodiments. Network devices in accordance with various embodiments can include any number of ports 605 that provide network communications with other computing and/or network devices.

Merely by way of example, the network device 600 includes eight ports 605a, ... 605h; other embodiments might include fewer (*e.g.,* four) or more (*e.g.,* 12, 24, 48, etc.) ports than those illustrated in Fig. 6. In some cases, the number of ports might vary by the nature of the network device. Merely by way of example, many enterprise switches often include up to 52 ports (which might include, *e.g.,* four uplink ports), and modular switches can scale to over 1000 ports, while routers and firewalls might include between four and twelve ports, with modular routers scaling up to 100 ports. In many cases, as the number of ports increases, the I/O density increases, and semiconductors featuring microvias, in some embodiments, support greater I/O density (*e.g.,* due to their ability to operate at higher speeds without the deleterious effects of impedance mismatch) than conventional semiconductors.

Each of the ports 605 generally is configured to accept a connection (*e.g.,* an RJ45, a GG45 connection, a small form pluggable (SFP) or SFP+ connection, etc.) with a network cable, which might include copper Ethernet (twisted-pair) cable (*e.g.,* Category 6, 6a, 7, and/or 8 cables) that can support up to 25/40Gbps with bandwidths up to 2GHz, and/or fiber optic cable, such as multi-mode fiber, single-mode fiber, etc. supporting up to 100Gbps (*e.g.,* 100GBASE-LR).

In some embodiments, the network device 600 includes switching electronics 610, which is used broadly to refer to any set of electronics and/or circuitry that handles packet processing tasks, such as packet forwarding, packet routing, packet inspection, and/or the like. In some aspects, the switching electronics 610 provides a switch fabric that interconnects the ports 605, *e.g.,* using a crossbar or multistage interconnect. In some embodiments, the switching electronics will include one or more semiconductor devices 620, which can include without limitation semiconductor devices such as those described above, that employ one or more via structures, as that term is used above, such as ASICS, SoCs, NPUs, fabric chips, and/or the like. In some embodiments, the network device can include a standalone processor 615 that also is a semiconductor device comprising one or more via structures, such as a control plane CPU (*e.g.,* an ARM processor, x86 processor, etc.)..

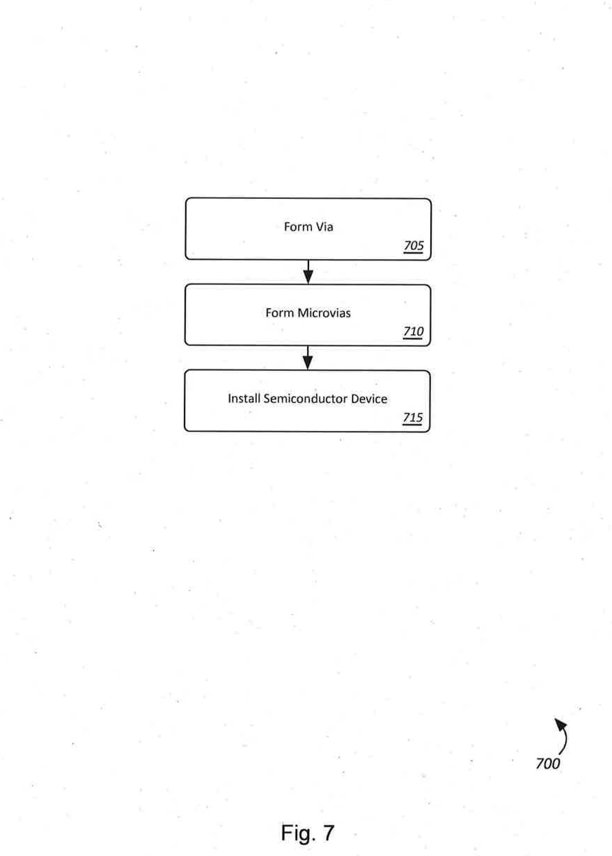

Some embodiments also provide methods, such as methods of producing and/or using semiconductor devices comprising one or more via structures, including without limitation as those described above. Fig. 7, for example, illustrates a method 700 of producing a semiconductor device (which again can be an IC, a package, and/or a packaged IC).

In some embodiments, the method comprises forming a via (*e.g.,* using conventional techniques, such as those described above) (block 705) and/or forming a set of microvias (block 710). In some embodiments, the method 700 can comprise performing these operations a plurality of times to produce a plurality of via structures. In some cases, a plurality (*e.g.,* two) via structures might be formed as part of a differential signal path of a differential pair (*e.g.,* as described above), and/or a first set of microvias might be part of a positive terminal of the differential pair while a second set of microvias might be part of a negative terminal of the differential pair. In some cases, as noted above, the via structures, and/or differential pairs comprising such via structures, can be part of a SERDES block in the semiconductor. Semiconductors in . accordance with some embodiments might comprise a plurality of SERDES blocks, for example, a SERDES block for each lane in a NPU. In some embodiments, producing the semiconductor might include manufacturing any other components, layers, interconnect, etc. that is necessary and/or appropriate for operation of the semiconductor, *e.g.,* as known in the art.

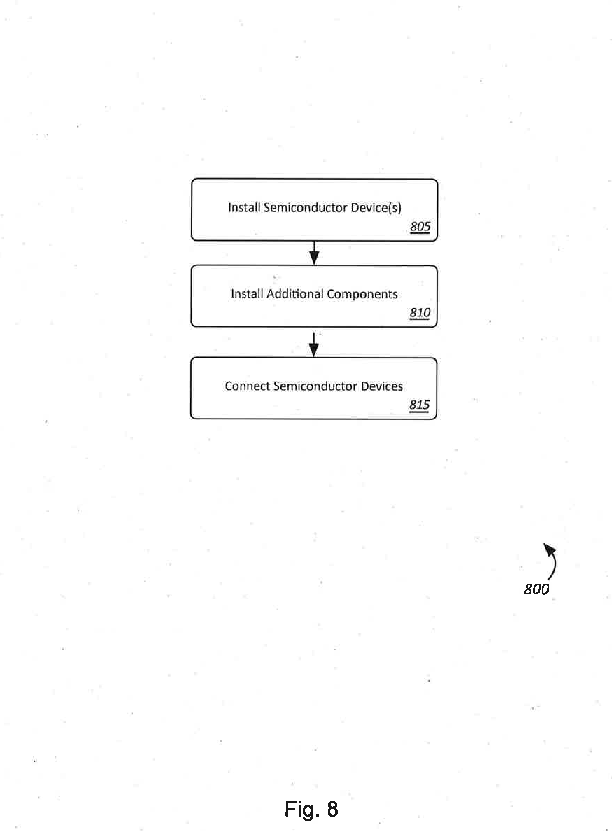

Fig. 8 illustrates a method 800 of producing a device, such as a computing device and/or a networking device, that comprises one or more semiconductors, including without limitation semiconductors as described above. In some embodiments, the method 800 comprises installing a semiconductor in a device. Installing the semiconductor can include a number of operations, which often depend on the nature of the IC or package comprised by the semiconductor device. For example, if the semiconductor device comprises a surface mount package (*e.g.,* a BGA package), installing the semiconductor device can comprise soldering the BGA package to a PCB. Conversely, if the semiconductor device comprises a socket-based connection, installing the semiconductor device might comprise inserting the semiconductor device into a socket on a PCB.

At block 805, the method can comprise manufacturing and/or installing additional components of the device. Such additional components can include any components necessary or appropriate for such a device, and they often will depend on the type of device. Merely by way of example, if the device is a network device, additional components can include the PCB hosting one or more of the semiconductor devices, network ports, activity lights, power supplies, additional processor(s), and/or the like.

In some embodiments, the method can comprise connecting the semiconductor device(s) with some or all of the additional components. Connecting the semiconductor device can comprise a number of operations. Such operations can comprise, without limitation, connecting the semiconductor device(s) to one or more PCBs hosting the semiconductor devices, connecting the semiconductor device(s) (and/or the PCB(s) hosting the semiconductor devices) to other switching electronics, ports, processors, power, ground, etc., and/or any other operations conventionally performed in the manufacture, assembly, and/or production of a network device (or other device comprising the semiconductor device(s)).

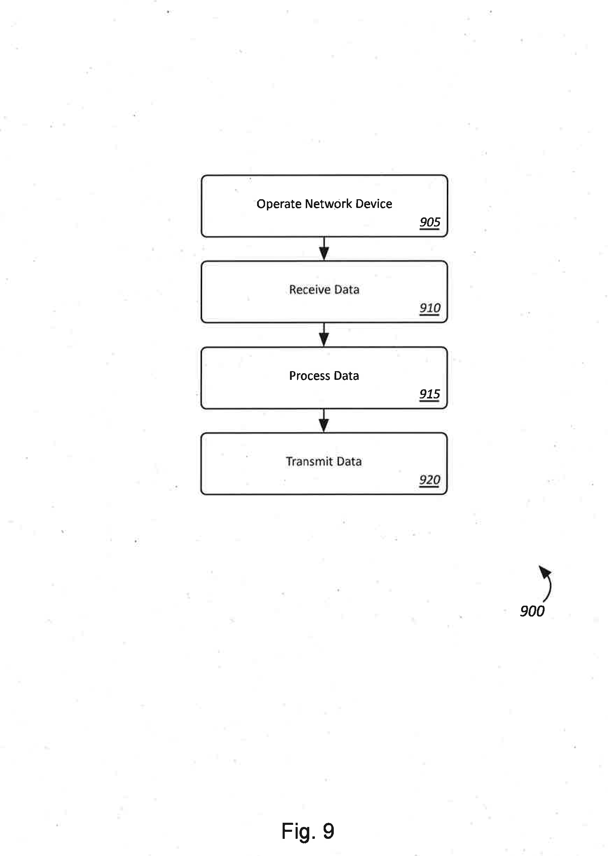

Fig. 9 illustrates a method 900 of using a semiconductor device (and/or a device, such as a network device) comprising the semiconductor device. At block 905, the method 900 comprises operating the device. Operating a device, such as a network device, can comprise any number of operations, including without limitation connecting the device to a network (*e.g.,* via one or more ports of the device), providing power to the device, configuring the device, and/or the like.

At block 910, the method comprises receiving data with the device and/or from another device, *e.g.,* over a network, through a network port of the device, etc. At block 915, the method might comprise processing the received data. Processing the received data can comprise any operations that modify, manipulate, inspect, and/or otherwise handle the data. Merely by way of example, in the case of a network device, the data might be received via a source port as a set or stream of data packets, and processing the data can comprise any or all of the packet processing operations described above, such as forwarding or routing data from the source port to one or more destination ports, performing packet inspection, and/or the like.

At block 920, the method can comprise transmitting data, *e.g.,* data processed in accordance with block 915. Merely by way of example, in the case of a network device that processed data by routing it from a source port to one or more destination ports, transmitting the data might comprise transmitting the data via the one or more destination ports. In the case of a computing device, where processing the data might comprise performing one or more compute operations on the data, transmitting the data might comprise transmitting the data that is the result of the compute operation(s) and/or data modified by the compute operation(s).

### Further Examples

The following examples described various features of certain embodiments. All such features of each example described below can be combined in any fashion, and different embodiments thus can include any set or subset of the features described below, as well as various features of the embodiments described above. No particular feature or set of features should be considered required by all embodiments. Conversely, some embodiments can combine some or all of these features in any manner understood, in light of this disclosure, by a skilled artisan.

One set of embodiments provides packages for integrated circuits. An exemplary package in accordance with some embodiments comprises a via structure. In some embodiments, the via structure comprises a first signal via extending through a first layer of the package. In some embodiments, the via structure comprises a first set of signal microvias. In some embodiments, the first set of signal microvias comprises a first plurality of signal microvias. In some embodiments, the first set of signal microvias extends through a second layer of the package. In some embodiments, the first set of signal microvias are in electrical communication with the first signal via. In some embodiments, the first layer is above the second layer. In some embodiments, the first layer is below the second layer.

In some embodiments, the package comprises a core area. In some embodiments, the second layer is disposed in the core area. In some embodiments, the package comprise a die breakout area. In some embodiments, the second layer is disposed in the die breakout area. In some embodiments, the package comprises a bottom buildup area. In some embodiments, the second layer is disposed the bottom buildup area. In some embodiments, the package comprises a ball gate array (BGA).

In some embodiments, the first plurality of signal microvias are disposed in parallel. In some embodiments, the first plurality of signal microvias consists of two signal microvias. In some embodiments, each of the signal microvias has substantially a same cross-sectional area and substantially a same height.

In some embodiments, the package comprises a second signal via extending through the first layer. In some embodiments, the package comprises a second set of signal microvias. In some embodiments, the second set of signal microvias comprises a second plurality of microvias extending through the second layer and/or in electrical communication with the second signal via. In some embodiments, the first set of signal microvias is part of a positive signal path of a differential pair for high-speed signaling. In some embodiments, the second set of signal microvias is part of a negative signal path of the differential pair. In some embodiments, the high-speed signaling operates at a clock rate of at least 45 GHz.

In some embodiments, a ratio of a positive/negative terminal spacing between the first set of signal microvias and the and second set of signal microvias to a height of the signal microvias is between 1.7 and 1.9. In some embodiments, a ratio of a positive/negative terminal spacing between the first plurality of signal microvias and a and second plurality of signal microvias to a height of each of the signal microvias is between 1.5 and 2.1. In some embodiments, a ratio of a spacing between each of the signal microvias and a height of each of at least one of the signal microvias is between 0.48 and 0.56. In some embodiments, a ratio of a spacing between each of the signal microvias and a height at least one of the signal microvias is between 0.4 and 0.6. In some embodiments, a ratio of a spacing between the first set of signal microvias and a ground microvia to a height of the at least one of the signal microvias is between 0.8 and 1.0.

One set of embodiments provides semiconductor devices. An exemplary semiconductor device in accordance with some embodiments comprises a via structure. In some embodiments, the semiconductor device comprises an integrated circuit and a package. In some embodiments, the package comprises the via structure. In some embodiments, the semiconductor device comprises an integrated circuit. In some embodiments, the integrated circuit comprises the via structure.

In some embodiments, the via structure comprises a first signal via extending through a first layer of the semiconductor device. In some embodiments, the via structure comprises a first set of signal microvias. In some embodiments, the first set of signal microvias comprises a first plurality of signal microvias. In some embodiments, the first set of signal microvias extends through a second layer of the semiconductor device. In some embodiments, the first plurality microvias are in electrical communication with the first signal via. In some embodiments, the first layer is above the second layer. In some embodiments, the first layer is below the second layer.

In some embodiments, the semiconductor device comprises a core area. In some embodiments, the second layer is disposed in the core area. In some embodiments, the semiconductor device comprise a die breakout area. In some embodiments, the second layer is disposed in the die breakout area. In some embodiments, the semiconductor device comprises a bottom buildup area. In some embodiments, the second layer is disposed in the bottom buildup area. In some embodiments, the semiconductor device comprises a ball gate array (BGA).

In some embodiments, the first plurality of signal microvias are disposed in parallel. In some embodiments, the first plurality of signal microvias consists of two signal microvias. In some embodiments, each of the signal microvias has substantially a same cross-sectional area and substantially a same height.

In some embodiments, the semiconductor device comprises a second signal via extending through the first layer. In some embodiments, the semiconductor device comprises a second set of signal microvias. In some embodiments, the second set of signal microvias comprises a second plurality of signal microvias extending through the second layer and/or in electrical communication with the second signal via. In some embodiments, the first set of signal microvias is part of a positive signal path of a differential pair for high-speed signaling. In some embodiments, the second set of signal microvias is part of a negative signal path of the differential pair. In some embodiments, the high-speed signaling operates at a clock rate of at least 45 GHz.

In some embodiments, a ratio of a positive/negative terminal spacing between the first set of signal microvias and the and second set of signal microvias to a height of the signal microvias is between 1.7 and 1.9. In some embodiments, a ratio of a positive/negative terminal spacing between the first plurality of signal microvias and a and second plurality of signal microvias to a height of each of the signal microvias is between 1.5 and 2.1. In some embodiments, a ratio of a spacing between each of the signal microvias and a height of each of at least one of the signal microvias is between 0.48 and 0.56. In some embodiments, a ratio of a spacing between each of the signal microvias and a height at least one of the signal microvias is between 0.4 and 0.6. In some embodiments, a ratio of a spacing between the first set of signal microvias and a ground microvia to a height of the at least one of the signal microvias is between 0.8 and 1.0.

Another set of embodiments comprises network devices. In some embodiments, the network device is a switch. In some embodiments, the network device is a router. In some embodiments, the network device comprises a semiconductor device. In some embodiments, the semiconductor device comprises a via structure. In some embodiments, the semiconductor device comprises an integrated circuit and a package. In some embodiments, the package comprises the via structure. In some embodiments, the semiconductor device comprises an integrated circuit. In some embodiments, the integrated circuit comprises the via structure.

In some embodiments, the via structure comprises a first signal via extending through a first layer of the semiconductor device. In some embodiments, the via structure comprises a first set of signal microvias. In some embodiments, the first set of signal vias comprises a first plurality of signal microvias. In some embodiments, the first set of signal vias extends through a second layer of the semiconductor device. In some embodiments, the first set of signal vias are in electrical communication with the first signal via. In some embodiments, the first layer is above the second layer. In some embodiments, the first layer is below the second layer.

In some embodiments, the semiconductor device comprises a core area. In some embodiments, the second layer is disposed in the core area. In some embodiments, the semiconductor device comprise a die breakout area. In some embodiments, the second layer is disposed in the die breakout area. In some embodiments, the semiconductor device comprises bottom buildup area. In some embodiments, the second layer is disposed in the bottom buildup area. In some embodiments, the semiconductor device comprises a ball gate array (BGA).

In some embodiments, the first plurality of signal microvias are disposed in parallel. In some embodiments, the first plurality of signal microvias consists of two signal microvias. In some embodiments, each of the signal microvias has substantially a same cross-sectional area and substantially a same height.

In some embodiments, the semiconductor device comprises a second signal via extending through the first layer. In some embodiments, the semiconductor device comprises a second set of signal microvias. In some embodiments, the second set of microvias comprises a second plurality of microvias extending through the second layer and/or in electrical communication with the second signal via. In some embodiments, the first set of signal microvias is part of a positive signal path of a differential pair for high-speed signaling. In some embodiments, the second set of signal microvias is part of a negative signal path of the differential pair. In some embodiments, the high-speed signaling operates at a clock rate of at least 45 GHz.

In some embodiments, a ratio of a positive/negative terminal spacing between the first set of signal microvias and the and second set of signal microvias to a height of the signal microvias is between 1.7 and 1.9. In some embodiments, a ratio of a positive/negative terminal spacing between the first plurality of signal microvias and a and second plurality of signal microvias to a height of each of the signal microvias is between 1.5 and 2.1. In some embodiments, a ratio of a spacing between each of the signal microvias and a height of each of at least one of the signal microvias is between 0.48 and 0.56. In some embodiments, a ratio of a spacing between each of the signal microvias and a height at least one of the signal microvias is between 0.4 and 0.6. In some embodiments, a ratio of a spacing between the first set of signal microvias and a ground microvia to a height of the at least one of the signal microvias is between 0.8 and 1.0.

Another set of embodiments provides methods. An exemplary method in accordance with some embodiments produces a packages for an integrated circuit. In some embodiments, the package comprises a via structure. In some embodiments, the method comprises forming the via structure.

In some embodiments, the package comprises a via structure. In some embodiments, the via structure comprises a first signal via extending through a first layer of the package. In some embodiments, the via structure comprises a first set of signal microvias. In some embodiments, the first set of signal microvias comprises a first plurality of signal microvias. In some embodiments, the first set of signal microvias extends through a second layer of the package. In some embodiments, the first set of signal microvias are in electrical communication with the first signal via. In some embodiments, the first layer is above the second layer. In some embodiments, the first layer is below the second layer.

In some embodiments, the package comprises a core area. In some embodiments, the second layer is disposed in the core area. In some embodiments, the package comprise a die breakout area. In some embodiments, the second layer is disposed in the die breakout area. In some embodiments, the package comprises a bottom buildup area. In some embodiments, the second layer is disposed in the bottom buildup area. In some embodiments, the package comprises a ball gate array (BGA).

In some embodiments, the first plurality of signal microvias are disposed in parallel. In some embodiments, the first plurality of signal microvias consists of two signal microvias. In some embodiments, each of the signal microvias has substantially a same cross-sectional area and substantially a same height.

In some embodiments, the package comprises a second signal via extending through the first layer. In some embodiments, the package comprises a second set of signal microvias. In some embodiments, the second set of signal microvias comprises a second plurality of microvias extending through the second layer and/or in electrical communication with the second signal via. In some embodiments, the first set of signal microvias is part of a positive signal path of a differential pair for high-speed signaling. In some embodiments, the second set of signal microvias is part of a negative signal path of the differential pair. In some embodiments, the high-speed signaling operates at a clock rate of at least 45 GHz.

In some embodiments, a ratio of a positive/negative terminal spacing between the first set of signal microvias and the and second set of signal microvias to a height of the signal microvias is between 1.7 and 1.9. In some embodiments, a ratio of a positive/negative terminal spacing between the first plurality of signal microvias and a and second plurality of signal microvias to a height of each of the signal microvias is between 1.5 and 2.1. In some embodiments, a ratio of a spacing between each of the signal microvias and a height of each of at least one of the signal microvias is between 0.48 and 0.56. In some embodiments, a ratio of a spacing between each of the signal microvias and a height at least one of the signal microvias is between 0.4 and 0.6. In some embodiments, the method can comprise forming a ground microvia. In some embodiments, a ratio of a spacing between the first set of signal microvias and a ground microvia to a height of the at least one of the signal microvias is between 0.8 and 1.0.

Another exemplary method in accordance with some embodiments produces a semiconductor device. In some embodiments, the semiconductor device comprises a via structure. In some embodiments, the semiconductor device comprises an integrated circuit and a package. In some embodiments, the package comprises the via structure. In some embodiments, the semiconductor device comprises an integrated circuit. In some embodiments, the integrated circuit comprises the via structure. In some embodiments, the method comprises forming the via structure.

In some embodiments, the via structure comprises a first signal via extending through a first layer of the semiconductor device, and the method can comprise forming the first signal via. In some embodiments, the via structure comprises a first set of signal microvias, and the method can comprise forming the first set of signal microvias. In some embodiments, the first set of signal microvias comprises a first plurality of signal microvias. In some embodiments, the first set of signal microvias extends through a second layer of the semiconductor device. In some embodiments, the first plurality microvias are in electrical communication with the first signal via. In some embodiments, the first layer is above the second layer. In some embodiments, the first layer is below the second layer.

In some embodiments, the semiconductor device comprises a core area. In some embodiments, the second layer is disposed in the core area. In some embodiments, the semiconductor device comprise a die breakout area. In some embodiments, the second layer is disposed in the die breakout area. In some embodiments, the semiconductor device comprises a bottom buildup area. In some embodiments, the second layer is disposed in the bottom buildup area. In some embodiments, the semiconductor device comprises a ball gate array (BGA).

In some embodiments, the first plurality of signal microvias are disposed in parallel. In some embodiments, the first plurality of signal microvias consists of two signal microvias. In some embodiments, each of the signal microvias has substantially a same cross-sectional area and substantially a same height.

In some embodiments, the semiconductor device comprises a second signal via extending through the first layer, and the method can comprise forming the second signal via. In some embodiments, the semiconductor device comprises a second set of signal microvias, and the method can comprise forming the second set of signal microvias. In some embodiments, the second set of signal microvias comprises a second plurality of signal microvias extending through the second layer and/or in electrical communication with the second signal via. In some embodiments, the first set of signal microvias is part of a positive signal path of a differential pair for high-speed signaling. In some embodiments, the second set of signal microvias is part of a negative signal path of the differential pair. In some embodiments, the high-speed signaling operates at a clock rate of at least 45 GHz.

In some embodiments, a ratio of a positive/negative terminal spacing between the first set of signal microvias and the and second set of signal microvias to a height of the signal microvias is between 1.7 and 1.9. In some embodiments, a ratio of a positive/negative terminal spacing between the first plurality of signal microvias and a and second plurality of signal microvias to a height of each of the signal microvias is between 1.5 and 2.1. In some embodiments, a ratio of a spacing between each of the signal microvias and a height of each of at least one of the signal microvias is between 0.48 and 0.56. In some embodiments, a ratio of a spacing between each of the signal microvias and a height at least one of the signal microvias is between 0.4 and 0.6. In some embodiments, the method can comprise forming a ground via. In some embodiments, a ratio of a spacing between the first set of signal microvias and a ground microvia to a height of the at least one of the signal microvias is between 0.8 and 1.0.

Another exemplary method in accordance with some embodiments produces network devices. In some embodiments, the network device is a switch. In some embodiments, the network device is a router. In some embodiments, the network device comprises a semiconductor device. In some embodiments, the semiconductor device comprises a via structure. In some embodiments, the semiconductor device comprises an integrated circuit and a package. In some embodiments, the package comprises the via structure. In some embodiments, the semiconductor device comprises an integrated circuit. In some embodiments, the integrated circuit comprises the via structure. In some embodiments, the method comprises forming the via structure.

In some embodiments, the via structure comprises a first signal via extending through a first layer of the semiconductor device, and the method can comprise forming the first signal via. In some embodiments, the via structure comprises a first set of signal microvias, and the method can comprise forming the first set of signal microvias. In some embodiments, the first set of signal microvias comprises a first plurality of signal microvias. In some embodiments, the first set of signal microvias extends through a second layer of the semiconductor device. In some embodiments, the first plurality microvias are in electrical communication with the first signal via. In some embodiments, the first layer is above the second layer. In some embodiments, the first layer is below the second layer.

In some embodiments, the semiconductor device comprises a core area. In some embodiments, the second layer is disposed in the core area. In some embodiments, the semiconductor device comprise a die breakout area. In some embodiments, the second layer is disposed in the die breakout area. In some embodiments, the semiconductor device comprises a bottom buildup area. In some embodiments, the second layer is disposed in the bottom buildup area. In some embodiments, the semiconductor device comprises a ball gate array (BGA).

In some embodiments, the first plurality of signal microvias are disposed in parallel. In some embodiments, the first plurality of signal microvias consists of two signal microvias. In some embodiments, each of the signal microvias has substantially a same cross-sectional area and substantially a same height.

In some embodiments, the semiconductor device comprises a second signal via extending through the first layer, and the method can comprise forming the second signal via. In some embodiments, the semiconductor device comprises a second set of signal microvias, and the method can comprise forming the second set of signal microvias. In some embodiments, the second set of signal microvias comprises a second plurality of signal microvias extending through the second layer and/or in electrical communication with the second signal via. In some embodiments, the first set of signal microvias is part of a positive signal path of a differential pair for high-speed signaling. In some embodiments, the second set of signal microvias is part of a negative signal path of the differential pair. In some embodiments, the high-speed signaling operates at a clock rate of at least 45 GHz.

In some embodiments, a ratio of a positive/negative terminal spacing between the first set of signal microvias and the and second set of signal microvias to a height of the signal microvias is between 1.7 and 1.9. In some embodiments, a ratio of a positive/negative terminal spacing between the first plurality of signal microvias and a and second plurality of signal microvias to a height of each of the signal microvias is between 1.5 and 2.1. In some embodiments, a ratio of a spacing between each of the signal microvias and a height of each of at least one of the signal microvias is between 0.48 and 0.56. In some embodiments, a ratio of a spacing between each of the signal microvias and a height at least one of the signal microvias is between 0.4 and 0.6. In some embodiments, the method can comprise forming a ground via. In some embodiments, a ratio of a spacing between the first set of signal microvias and a ground microvia to a height of the at least one of the signal microvias is between 0.8 and 1.0.

Another exemplary method in accordance with some embodiments comprises operating a network device. In some embodiments, the method might further comprise transmitting data with the network device. In some embodiments, the network device is a switch. In some embodiments, the network device is a router. In some embodiments, the network device comprises a semiconductor device. In some embodiments, the semiconductor device comprises a via structure. In some embodiments, the semiconductor device comprises an integrated circuit and a package. In some embodiments, the package comprises the via structure. In some embodiments, the semiconductor device comprises an integrated circuit. In some embodiments, the integrated circuit comprises the via structure. In some embodiments, the method comprises forming the via structure.

In some embodiments, the via structure comprises a first signal via extending through a first layer of the semiconductor device, and the method can comprise forming the first signal via. In some embodiments, the via structure comprises a first set of signal microvias, and the method can comprise forming the first set of signal microvias. In some embodiments, the first set of signal microvias comprises a first plurality of signal microvias. In some embodiments, the first set of signal microvias extends through a second layer of the semiconductor device. In some embodiments, the first plurality microvias are in electrical communication with the first signal via. In some embodiments, the first layer is above the second layer. In some embodiments, the first layer is below the second layer.

In some embodiments, the semiconductor device comprises a core area. In some embodiments, the second layer is disposed in the core area. In some embodiments, the semiconductor device comprise a die breakout area. In some embodiments, the second layer is disposed in the die breakout area. In some embodiments, the semiconductor device comprises a bottom buildup area. In some embodiments, the second layer is disposed in the bottom buildup area. In some embodiments, the semiconductor device comprises a ball gate array (BGA).

In some embodiments, the first plurality of signal microvias are disposed in parallel. In some embodiments, the first plurality of signal microvias consists of two signal microvias. In some embodiments, each of the signal microvias has substantially a same cross-sectional area and substantially a same height.

In some embodiments, the semiconductor device comprises a second signal via extending through the first layer, and the method can comprise forming the second signal via. In some embodiments, the semiconductor device comprises a second set of signal microvias, and the method can comprise forming the second set of signal microvias. In some embodiments, the second set of signal microvias comprises a second plurality of signal microvias extending through the second layer and/or in electrical communication with the second signal via. In some embodiments, the first set of signal microvias and the second set of signal microvias are part of a differential pair for high-speed signaling. In some embodiments, the high-speed signaling operates at a clock rate of at least 45 GHz.

In some embodiments, a ratio of a positive/negative terminal spacing between the first set of signal microvias and the and second set of signal microvias to a height of the signal microvias is between 1.7 and 1.9. In some embodiments, a ratio of a positive/negative terminal spacing between the first plurality of signal microvias and a and second plurality of signal microvias to a height of each of the signal microvias is between 1.5 and 2.1. In some embodiments, a ratio of a spacing between each of the signal microvias and a height of each of at least one of the signal microvias is between 0.48 and 0.56. In some embodiments, a ratio of a spacing between each of the signal microvias and a height at least one of the signal microvias is between 0.4 and 0.6. In some embodiments, the method can comprise forming a ground via. In some embodiments, a ratio of a spacing between the first set of signal microvias and a ground microvia to a height of the at least one of the signal microvias is between 0.8 and 1.0.

### Conclusion

In the foregoing description, for the purposes of explanation, numerous details are set forth to provide a thorough understanding of the described embodiments. It will be apparent to one skilled in the art, however, that other embodiments may be practiced without some of these details. In other instances, structures and devices are shown in block diagram form without full detail for the sake of clarity. Several embodiments are described herein, and while various features are ascribed to different embodiments, it should be appreciated that the features described with respect to one embodiment may be incorporated with other embodiments as well. By the same token, however, no single feature or features of any described embodiment should be considered essential to every embodiment of the invention, as other embodiments of the invention may omit such features.

Thus, the foregoing description provides illustration and description of some features and aspect of various embodiments, but it is not intended to be exhaustive or to limit the embodiments in general to the precise form disclosed. One skilled in the art will recognize that modifications may be made in light of the above disclosure or may be acquired from practice of the implementations, all of which can fall within the scope of various embodiments. For example, as noted above, the methods and processes described herein may be implemented using software components, firmware and/or hardware components (including without limitation processors, other hardware circuitry, custom integrated circuits (ICs), programmable logic, etc.), and/or any combination thereof.

Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Likewise, while the procedures of the methods and processes described herein are described in a particular order for ease of description, unless the context dictates otherwise, various procedures may be reordered, added, and/or omitted in accordance with various embodiments. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various embodiments are described with or without some features for ease of description and to illustrate aspects of those embodiments, the various components and/or features described herein with respect to a particular embodiment can be substituted, added and/or subtracted from among other described embodiments, unless the context dictates otherwise.

As used herein, the term "component" is intended to be broadly construed as hardware, firmware, software, or a combination of any of these. It will be apparent that systems and/or methods described herein may be implemented in different forms of hardware, firmware, and/or a combination of hardware and software. The actual specialized control hardware or software code used to implement these systems and/or methods does not limit any embodiments unless specifically recited in the claims below. Thus, when the operation and behavior of the systems and/or methods are described herein without reference to specific software code, one skilled in the art would understand that software and hardware can be used to implement the systems and/or methods based on the description herein.

In this disclosure, when an element is referred to herein as being "connected" or "coupled" to another element, it is to be understood that one element can be directly connected to the other element or have intervening elements present between the elements. In contrast, when an element is referred to as being "directly connected" or "directly coupled" to another element, it should be understood that no intervening elements are present in the "direct" connection between the elements. However, the existence of a direct connection does not preclude other connections, in which intervening elements may be present. Similarly, while the methods and processes described herein may be described in a particular order for ease of description, it should be understood that, unless the context dictates otherwise, intervening processes may take place before and/or after any portion of the described process, and, as hoted above, described procedures may be reordered, added, and/or omitted in accordance with various embodiments.

In this application, the use of the singular includes the plural unless specifically stated otherwise, and use of the term "and" means "and/or" unless otherwise indicated. Also, as used herein, the term "or" is intended to be inclusive when used in a series and also may be used interchangeably with "and/or," unless explicitly stated otherwise (*e.g.,* if used in combination with "either" or "only one of"). Moreover, the use of the term "including," as well as other forms, such as "includes" and "included," should be considered non-exclusive. Also, terms such as "element" or "component" encompass both elements and components comprising one unit and elements and components that comprise more than one unit, unless specifically stated otherwise. As used herein, the phrase "at least one of" preceding a series of items, with the term "and" or "or" to separate any of the items, modifies the list as a whole, rather than each member of the list (*i.e.,* each item). The phrase "at least one of" does not require selection of at least one of each item listed; rather, the phrase allows a meaning that includes at least one of any one of the items, and/or at least one of any combination of the items. By way of example, the phrases "at least one of A, B, and C" or "at least one of A, B, or C" each refer to only A, only B, or only C; and/or any combination of A, B, and C. In instances where it is intended that a selection be of "at least one of each of A, B, and C," or alternatively, "at least one of A, at least one of B, and at least one of C," it is expressly described as such.

Unless otherwise indicated, all numbers used herein to express quantities, dimensions, and so forth should be understood as being modified in all instances by the term "about." As used herein, the articles "a" and "an" are intended to include one or more items and may be used interchangeably with "one or more." Similarly, as used herein, the article "the" is intended to include one or more items referenced in connection with the article "the" and may be used interchangeably with "the one or more." As used herein, the term "set" is intended to include one or more items (*e.g.,* related items, unrelated items, a combination of related and unrelated items, and/or the like), and may be used interchangeably with "one or more." Where only one item is intended, the phrase "only one" or similar language is used. As used herein, the terms "has," "have," "having," or the like are intended to be open-ended terms. Further, the phrase "based on" is intended to mean "based, at least in part, on" unless explicitly stated otherwise. In the foregoing description, satisfying a threshold may, depending on the context, refer to a value being greater than the threshold, greater than or equal to the threshold, less than the threshold, less than or equal to the threshold, equal to the threshold, and/or the like, depending on the context.

Although particular combinations of features are recited in the claims and/or disclosed in the specification, these combinations are not intended to limit the disclosure of various implementations. In fact, many of these features may be combined in ways not specifically recited in the claims and/or disclosed in the specification. Thus, while each dependent claim listed below may directly depend on only one claim, the disclosure of various implementations includes each dependent claim in combination with every other claim in the claim set. No element, act, or instruction used herein should be construed as critical or essential unless explicitly described as such.

## Claims

1. A package for an integrated circuit, the package comprising:
a via structure, comprising:
a first signal via extending through a first layer of the package;
a first set of signal microvias comprising a first plurality of signal microvias extending through a second layer of the package and in electrical communication with the first signal via.

2. The package of claim 1, further comprising a core area, wherein the first set of signal microvias is disposed in the core area.

3. The package of claim 1 or 2, further comprising a die breakout area, wherein the first set of signal microvias is disposed in the die breakout area.

4. The package of any preceding claim, further comprising a bottom buildup area, wherein the first set of signal microvias is disposed in the bottom buildup area.

5. The package of any preceding claim, wherein the package comprises a ball gate array (BGA).

6. The package of any preceding, wherein the first plurality of signal microvias are disposed in parallel.

7. The package of any preceding, wherein the first plurality of signal microvias consists of two signal microvias.

8. The package of any preceding claim, wherein each of the signal microvias has substantially a same cross-sectional area and substantially a same height.

9. The package of any preceding claim, wherein the first layer is above the second layer.

10. The package of any preceding claim, further comprising:
a second signal via extending through the first layer;
a second set of signal microvias comprising a second plurality of signal microvias extending through the second layer and in electrical communication with the second signal via.

11. The package of claim 10, wherein the first set of signal microvias is part of a positive signal path of a differential pair for high-speed signaling and the second set of signal microvias is part of a negative signal path of the differential pair.

12. The package of claim 11, wherein the high-speed signaling operates at a clock rate of at least 45 GHz.

13. A semiconductor device comprising: ,
a via structure, comprising:
a first signal via extending through a first layer of the semiconductor device;
a first set of signal microvias comprising a first plurality of signal microvias extending through a second layer of the semiconductor device and in electrical communication with the first signal via;
a second signal via extending through the first layer; and
a second set of signal microvias comprising a second plurality of signal microvias extending through the second layer and in electrical communication with the second signal via;
wherein the first set of signal microvias is part of a positive signal path of a differential pair for high-speed signaling and the second set of signal microvias is part of a negative signal path of the differential pair.

14. The semiconductor device of claim 13, wherein the semiconductor device comprises an integrated circuit and a package, and wherein the package comprises the via structure.

15. A network device, comprising:
a semiconductor device, comprising:
a via structure comprising:
a signal via extending through a first layer of the semiconductor device; and
a plurality of signal microvias extending through a second layer of the semiconductor device and in electrical communication with the core via.
